# EUROPEAN PATENT APPLICATION

(11) **EP 4 425 725 A1**
(43) Date of publication of application: **04.09.2024**
(21) Application number: 22887693.4
(22) Date of filing: 28.10.2022
(51) Int. Cl.: H01S 5/062, H01S 5/50, H01S 3/10

(54) **LASER APPARATUS**

(30) Priority: 28.10.2021 KR 20210145876; 19.04.2022 KR 20220048325
(71) Applicant: Lutronic Corporation, Goyang-si, Gyeonggi-do 10534 (KR)
(72) Inventor: LEE, Hee Chul, Goyang-si, Gyeonggi-do 10322 (KR)
(74) Representative: Moosedog Oy
(86) International application number: PCT/KR2022/016687
(87) International publication number: WO 2023/075498

(57) **Abstract**

A disclosed laser device includes a laser diode configured to output laser light with a variable pulse pattern, a pre-amp optical unit configured to amplify the laser light output from the laser diode to a first energy level and includes a plurality of Pockels cells and a first amplifier, a second amplifier configured to amplify the laser light amplified to the first energy level to a second energy level, a third amplifier configured to amplify the laser light amplified to the second energy level to a third energy level, and a control unit configured to set a pulse pattern of the laser light output from the laser diode and control a driver of the laser diode, the first amplifier, the second amplifier, and the third amplifier based on the pulse pattern.

## Description

### Technical Field

Embodiments of the present disclosure relate to a laser device.

### Background Art

Laser beams are used in a variety of fields, including industrial, medical, and military applications. In particular, medical lasers may focus a certain amount of energy locally and enable a non-invasive treatment, and thus, the medical lasers are widely used in surgeries, internal medicine treatments, ophthalmology treatments, dermatology treatments, dentistry, and so on.

In laser treatments, lasers of different energy levels are needed depending on the treatment region or the location thereof, that is, the depth from the skin. Additionally, depending on the type of lesion, it may be necessary to use lasers with the same wavelength but different pulse widths. Accordingly, there is a demand for the development of a laser device that may output lasers with various types of pulse widths.

### Disclosure

### Technical Problem

A laser device that emits lasers having various pulse widths is provided.

### Technical Solution

According to an embodiment, there is provided a laser device including a laser diode configured to output laser light with a variable pulse pattern, a pre-amp optical unit configured to amplify the laser light output from the laser diode to a first energy level and including a plurality of Pockels cells and a first amplifier, a second amplifier configured to amplify the laser light amplified to the first energy level to a second energy level, a third amplifier configured to amplify the laser light amplified to the second energy level to a third energy level, and a control unit configured to set a pulse pattern of the laser light output from the laser diode and control a driver of the laser diode, the first amplifier, the second amplifier, and the third amplifier based on the pulse pattern.

The pulse pattern may include one or more pulses having a pulse width in a range of 50 pico seconds to 100 nano seconds.

The pre-amp optical unit may include a polarization beam splitter configured to reflect light of a first polarization and transmit light of a second polarization, a first Pockels cell arranged in a path of light reflected from the polarization beam splitter and controlled to operate as a quarter wave plate at a first timing, the first amplifier configured to amplify the light passing through the first Pockels cell, a first total reflection mirror configured to reflect the light amplified and output from the first amplifier back toward the first amplifier again, a second Pockels cell arranged to face the first Pockels cell with the polarization beam splitter between the first Pockels cell and the second Pockels cell and controlled to operate as a quarter wave plate at a second timing, and a second total reflection mirror configured to reflect the light passing through the second Pockels cell back toward the second Pockels cell again.

The laser light output from the laser diode may be the light of the first polarization.

The first timing may be a time from an instant when the laser light is reflected from the polarization beam splitter to an instant when the laser light reciprocates the first amplifier once and returns back to the polarization beam splitter again.

The second timing may be a time from an instant when the laser light reciprocates the first amplifier multiple times to an instant when the laser light has a first energy level and then reciprocates the second Pockels cell once.

The first energy level may be greater than or equal to 100 microjoules (µJ).

The number of times that the laser light reciprocates to the first amplifier may be 5 to 20 times.

The laser device may further include a first beam expansion unit configured to expand a beam width of the laser light amplified by the pre-amp optical unit.

The laser device may further include a second beam expansion unit configured to further expand the beam width expanded in the first beam expansion unit.

The laser device may further include a second harmonic wave generation unit arranged in a path of light output from the third amplifier.

The second harmonic wave generation unit may be driven to be inside or outside the path.

The laser device may further include a half wave plate arranged between the pre-amp optical unit and the second amplifier, a polarization beam splitter arranged between the half wave plate and the second amplifier, a quarter wave plate arranged between the polarization beam splitter and the second amplifier, and a total reflection mirror configured to reflect the light passing through the second amplifier back toward the second amplifier again.

The laser device may further include a half wave plate arranged between the second amplifier and the third amplifier, a polarization beam splitter arranged between the half wave plate and the third amplifier, a quarter wave plate arranged between the polarization beam splitter and the third amplifier, and a total reflection mirror configured to reflect the light passing through the third amplifier back toward the third amplifier again.

According to an embodiment, there is provided a treatment device including the laser device according to above description, and a control unit configured to control the laser device to output a pulse pattern suitable for a treatment mode.

The laser device may be configured to output light of a pulse pattern including only pico-second pulses, output light of a pulse pattern including only nano-second pulses, or output light of a pulse pattern including a combination of pico-second pulses and nano-second pulses.

### Advantageous Effects

The laser device described above may output laser having a pulse pattern in which one or more pulse widths are combined.

The laser device described above may be applied to a treatment device to set and output laser of a pulse pattern suitable for the lesion to be treated, thereby increasing the treatment effect.

### Description of Drawings

FIG. 1 is a conceptual block diagram illustrating a schematic configuration of a laser device according to embodiments.
FIG. 2 schematically illustrates an optical arrangement of a pre-amp optical unit provided in the laser device of FIG. 1.
FIGS. 3A to 3C are diagrams sequentially illustrating optical paths in which the pre-amp optical unit of FIG. 2 turns on/off a first Pockels cell and a second Pockels cell at a preset timing and amplifies and outputs incident laser light to a desired energy level.
FIG. 4 illustrates a schematic optical arrangement of a laser device according to an embodiment.
FIG. 5 illustrates a schematic optical arrangement of a laser device according to another embodiment.
FIG. 6 illustrates a schematic optical arrangement of a laser device according to another embodiment.
FIG. 7 is a block diagram illustrating a schematic configuration of a treatment device according to an embodiment.

### Mode for Invention

Since the present disclosure may be modified in various ways and may have various embodiments, certain embodiments are illustrated in the drawings and described in detail in the detailed description. The effects and features of the present disclosure and methods for achieving the effects and features will become clear by referring to the embodiments described in detail below along with the drawings. However, the present disclosure is not limited to the embodiments disclosed below and may be implemented in various forms.

Hereinafter, embodiments of the present disclosure are described in detail with reference to the accompanying drawings. When describing with reference to the drawings, identical or corresponding components are assigned the same reference numerals and redundant descriptions thereof are omitted.

In the following embodiments, terms such as first and second are used not in a limiting sense but for the purpose of distinguishing one component from another component.

In the following embodiments, singular terms include plural terms unless the context clearly dictates otherwise.

In the following embodiments, terms such as include or have mean that the features or components described in the specification exist, and do not exclude in advance the possibility of adding one or more other features or components.

In the following embodiments, when a part of a region, component, or so on is said to be on or above another part, this includes not only the case where the part is directly on top of the other part, but also the case where another region, component, and so on are interposed therebetween.

In the drawings, the sizes of components may be exaggerated or reduced for convenience of explanation. For example, the size and thickness of each component illustrated in the drawings are illustrated arbitrarily for convenience of explanation, so the present disclosure is not necessarily limited to what is illustrated.

In cases where an embodiment may be implemented differently, a certain process sequence may be performed differently from the described sequence. For example, two processes described in succession may also be performed substantially at the same time, or may be performed in an order opposite to the order to be described.

In the following embodiments, when regions, components, or so on are said to be connected, this includes not only the case where the regions and components are directly connected, but also the case where other regions and components are interposed between the regions and components, thereby indirectly connecting the components.

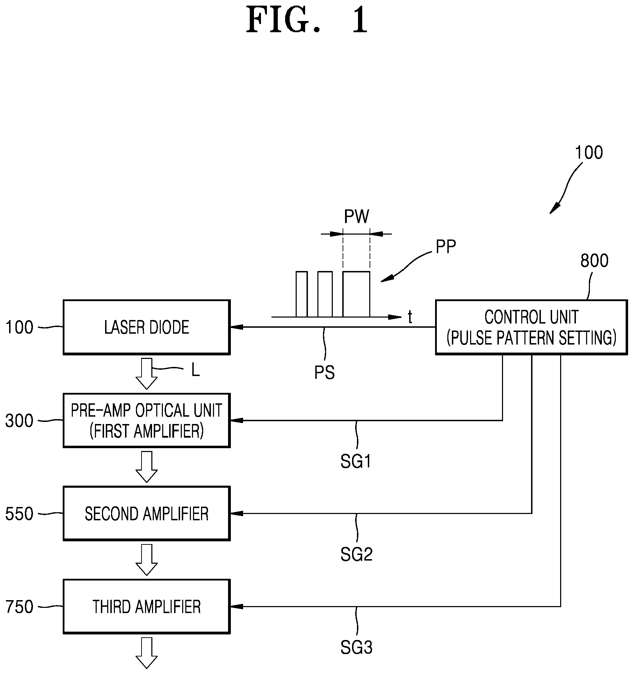

FIG. 1 is a conceptual block diagram illustrating a schematic configuration of a laser device according to embodiments.

A laser device 1000 includes a laser diode 100 that outputs laser light with a controlled pulse pattern, a pre-amp optical unit 300 that amplifies the laser light output from the laser diode 100 to a first energy level, a second amplifier 550 that amplifies the laser light amplified to the first energy level to a second energy level, a third amplifier 750 that amplifies the laser light amplified to the second energy level to a third energy level, and a control unit 800 that sets the pulse pattern of the laser light output from the laser diode 100 and controls a driver of the laser diode 100, the first amplifier 350, the second amplifier 550, and the third amplifier 750, based on the pulse pattern.

The laser diode 100 may form and output pulse patterns PP having various types of pulse widths PW. A pulse signal PS corresponding to the desired pulse pattern PP may be applied to the laser diode 100 using an output voltage and current of the laser driver, and thus laser light having a preset pulse pattern PP is output.

The pulse pattern PP output by the laser diode 100 may include one or more pulses having a pulse width PW in the range of 50 ps to 5 ns, or 50 ps to 100 ns. The laser diode 100 may output only pico-second (ps) pulses, and may output pico-second pulses of the same width or pico-second pulses of different widths at preset intervals. For example, when two pulses are output per second, pulses of 300 ps and 700 ps may be sequentially output. The laser diode 100 may output only nano-second (ns) pulses, and may output nano-second pulses of the same width, or nano-second pulses of different widths at preset intervals. The pulse pattern PP output by the laser diode 100 may be a combination of pico-second pulses and nano-second pulses. For example, when two pulses are output per second, pulses with pulse widths of 300 ps and 5 ns may be sequentially output. The numbers and combinations described are examples, and various pulse width combinations are possible, and repetition rates are also variable.

Energy of the laser light L output from the laser diode 100 is usually low from pico Joule (J) to nano Joule, and may go through several steps of amplification steps until the energy reaches a desired energy level.

First, the energy may be amplified to an energy level of hundreds of microjoules (µJ) to tens of millijoules (mJ) through the pre-amp optical unit 300. The pre-amp optical unit 300 includes a first amplifier, and may include optical elements that enable output after reaching a desired energy level after reciprocating the first amplifier multiple times, for example, several to tens of times. The pre-amp optical unit 300 may include, for example, a Pockels cell, a beam splitter, and so on in addition to the first amplifier.

Next, the laser light L amplified in the pre-amp optical unit 300 passes through the second amplifier 550 and the third amplifier 750, and may be amplified and output to have energy of hundreds of mJ to several J.

The control unit 800 may generate a pulse signal PS to be applied to the driver of the laser diode 100, and also control the pre-amp optical unit 300, the second amplifier 550, and the third amplifier 750 in conjunction with the pulse pattern PP of the laser light L generated according to the pulse signal PS. Control signals SG1, SG2, and SG3 applied from the control unit 800 to the pre-amp optical unit 300, the second amplifier 550, and the third amplifier 750 may be timing signals that turn on/off a pumping light source providing light to be supplied to each amplification medium.

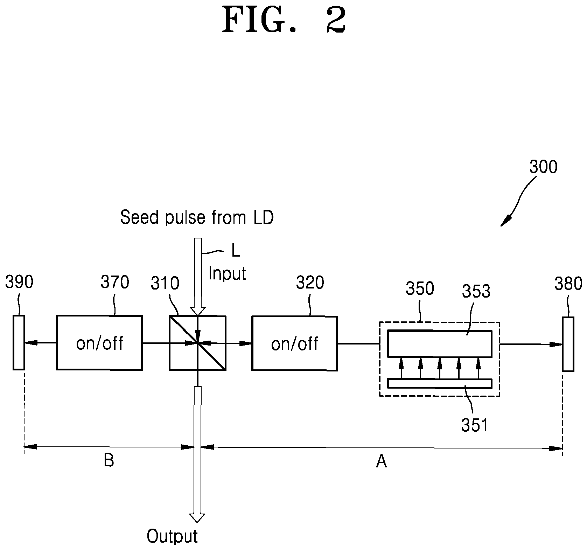

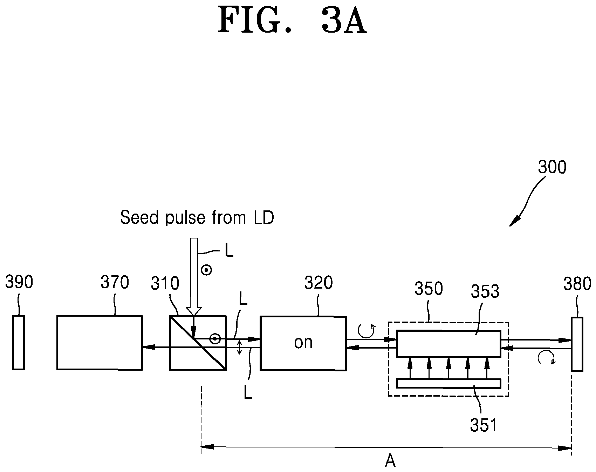

FIG. 2 schematically illustrates an optical arrangement of the pre-amp optical unit provided in the laser device according to embodiments. FIGS. 3A to 3C are diagrams sequentially illustrating optical paths in which the pre-amp optical unit of FIG. 2 turns on/off a first Pockels cell and a second Pockels cell at a preset timing and amplifies and outputs incident laser light to a desired energy level.

With reference to FIG. 2, the pre-amp optical unit 300 includes a polarization beam splitter 310 into which the laser light L, which has a seed pulse output from the laser diode 100, is input, a first Pockels cell 320 and a second Pockels cell 370 in a path of light reflected on the polarization beam splitter 310, a first amplifier 350 that amplifies the light passing through the first Pockels cell 320, a first total reflection mirror 380 that reflects the light amplified and output from the first amplifier 350 back toward the first amplifier 350, the second Pockels cell 370 facing the first Pockels cell 320 with the polarization beam splitter 310 interposed therebetween, and a second total reflection mirror 390 that reflects light passing through the second Pockels cell 370 back toward the second Pockels cell.

The polarization beam splitter 310 may reflect light of the first polarization and transmit the light of the second polarization perpendicular to the first polarization. The first polarization and the second polarization may be linear polarization, and the first polarization may be S polarization, and the second polarization may be P polarization. In the drawings below, the first polarization is indicated by o, and the second polarization is indicated by ↔.

The first Pockels Cell 320 and the second Pockels Cell 370 may control the phase of incident light using an electro-optical material that exhibits a phenomenon in which optical properties change according to an applied electrical signal. The first and second Pockels cells 320 and 370 are electrically controlled and may operate in a mode that maintains the phase of incident light (off) or may operate in a mode that delays the phase of incident light (on). For example, the first and second Pockels cells 320 and 370 may allow light to pass through without affecting the phase of the incident light when no electrical signal is applied, and may delay the phase of the incident light and allow light to pass through when a preset electrical signal is applied. However, the present disclosure is not limited thereto, and the first and second Pockels cells 320 and 370 may operate in a mode that maintains the phase of the incident light according to a preset electrical signal and may operate in a mode that delays the phase of the incident light according to another preset electrical signal. In the mode (on) that delays the phase of the incident light, the first and second Pockels cells 320 and 370 may operate as a quarter wave plate. In the embodiment, the first and second Pockels cells 320 and 370 are controlled to operate as the quarter wave plates at different timings.

The first amplifier 350 includes a first pumping light source 351 and a first amplification medium 353. The first pumping light source 351 may be a flash lamp or a laser diode, or may be various types of light sources that may provide light energy to the first amplification medium 353. The first pumping light source 351 receives power from a power supply (not illustrated) to emit light, and provides light to the first amplification medium 353. The first pumping light source 351 may be controlled by the control unit 800 to emit light in conjunction with the pulse pattern PP of the laser light L output from the laser diode 100. The first amplification medium 353 absorbs energy of light supplied from the first pumping light source 351, amplifies energy of the incident laser light L, and outputs it. The first amplification medium 353 may be Nd:YAG (neodymium-doped yttrium aluminum garnet), but is not limited thereto, and Nd:YAP (Neodymium:Yttrium-Aluminum-Perovskite), or Nd:YVO4 (Neodymium-doped yttrium orthovanadate), or so on may be used as the first amplification medium 353.

The laser light L amplified in the first amplifier 350 is reflected by the first total reflection mirror 380, is directed back to the first amplifier 350, passes through the first Pockels cell 320, the polarization beam splitter 310, the second Pockels cell 370, and then is reflected from the second total reflection mirror 390, thereby capable of reciprocating the first amplification medium 353 multiple times between the first total reflection mirror 380 and the second total reflection mirror 390.

In the pre-amp optical unit 300 of the embodiment, the first and second Pockels cells 320 and 370 may operate in the on mode at different timings, and accordingly, the laser light L incident through the polarization beam splitter 310 may reciprocate the first amplifier 350 until reaching a desired energy level, and then be output through the polarization beam splitter 310 again. Details are described with reference to FIGS. 3A to 3C.

With reference to FIG. 3A, the laser light L of the first polarization incident on the polarization beam splitter 310 is reflected from the polarization beam splitter 310 and is directed to the first Pockels cell 320. In this case, the first Pockels cell 320 is controlled in on mode and operates as the quarter wave plate. The laser light L of the first polarization passes through the first Pockels cell 320 and becomes circular polarization, for example, a right-circular polarization (RHC) state in the counterclockwise direction, and passes through the first amplifier 350, is reflected from the total reflection mirror 380, and becomes circular polarization in another direction, for example, a left-circular polarization (LHC) state in the clockwise direction. The first Pockels cell 320 remains the on state while the laser light reflected from the polarization beam splitter 310 reciprocates the first amplifier 350 once, that is, while the laser light reciprocates a section A, and accordingly, the polarization state of the light incident on the first Pockels cell 320 changes from the circular polarization to the second polarization. The light of the second polarization passes through the polarization beam splitter 310, that is, the laser light of the second polarization is not reflected from the polarization beam splitter 310 and passes through the polarization beam splitter 310 to be directed toward the second Pockels cell 370.

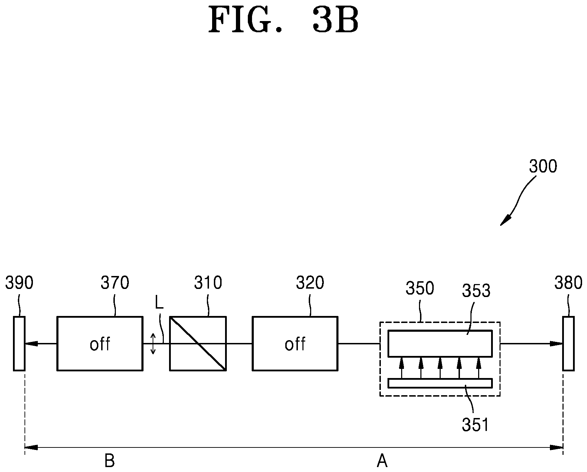

Next, referring to FIG. 3B, the first Pockels cell 320 and the second Pockels cell 370 are both in the off state, and the laser light L of the second polarization maintains the polarization state when passing through the first Pockels cell 320 and the second Pockels cell 370, and maintains the second polarization state in which the laser light L passes through the polarization beam splitter 310. Accordingly, the laser light L of the second polarization is reflected from the first total reflection mirror 380 and the second total reflection mirror 390, and reciprocates the A+B section, that is, reciprocates the first amplifier 350 multiple times. The number of reciprocations may be set to such an extent that the laser light L may reach a preset desired first energy level. The first energy level may be between hundreds of microjoules (µJ) and tens of millijoules (mJ), and, for example, equal to or greater than 100 microjoules (µJ).After the laser light L reciprocates the first amplifier 350 several to dozens of times, for example, 5-20 times, the energy level may range from hundreds of microjoules (µJ) to tens of millijoules (mJ) but this is an example.

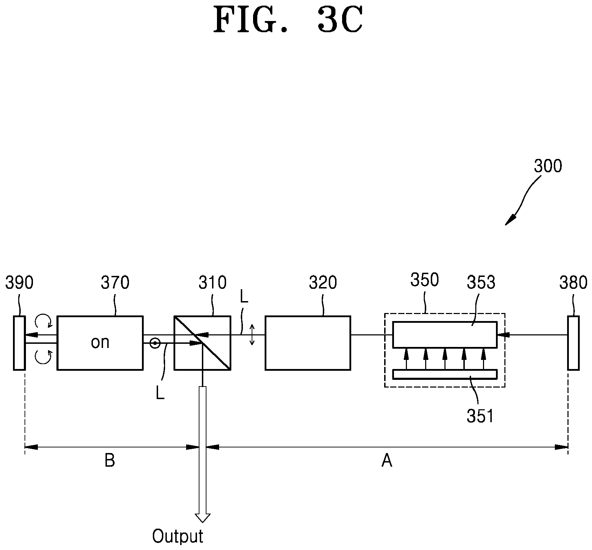

Next, referring to FIG. 3C, after energy of the laser light L reaches a preset desired energy level, the second Pockels cell 370 operates in the on mode, that is, operates as the quarter wave plate. The laser light L incident on the second Pockels cell 370 in the on mode passes through the second Pockels cell 370 and the polarization state changes from second polarization to circular polarization to the right-handed circular polarization (RHC) state in the clockwise direction. Next, the laser light L is reflected from the second total reflection mirror 390 and changes into the circular polarization in another direction, for example, changes into the left-handed circular polarization (LHC) in the counterclockwise direction, and is directed to the second Pockels cell 370. The second Pockels cell 370 remains the on state while the laser light L, which has a preset desired energy level, passes through the polarization beam splitter 310 and reciprocates the second Pockels cell 370 once, that is, reciprocates the section B once. The laser light L passes through the second Pockels cell 370 in the on state, changes its polarization state from the circular polarization to the first polarization, and is reflected and output from the polarization beam splitter 310.

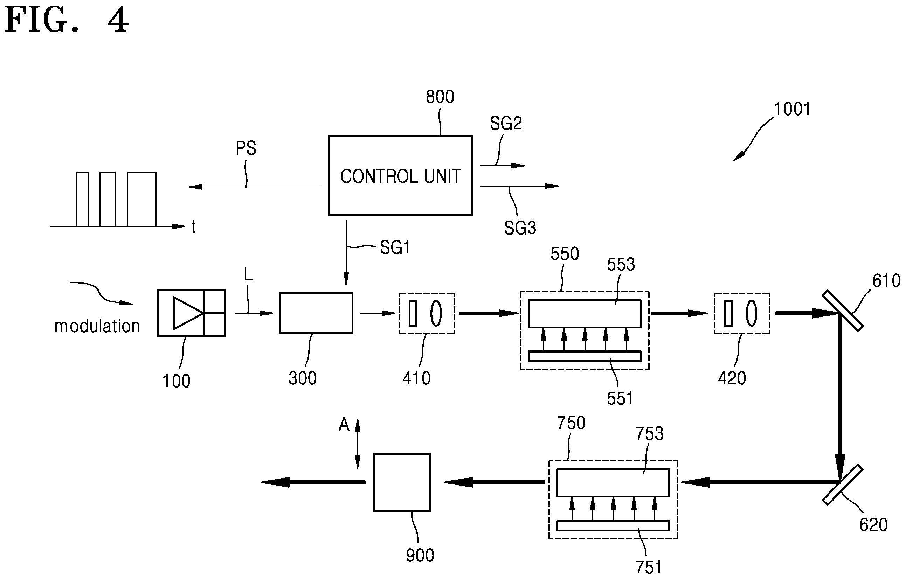

FIG. 4 illustrates a schematic optical arrangement of a laser device according to an embodiment.

The laser device 1001 includes the control unit 800, the laser diode 100 that is controlled by the control unit 800 and outputs the laser light L of a preset variable pulse pattern, the pre-amp optical unit 300 that primarily amplifies the laser light L output from the laser diode 100 and outputs the laser light L at the first energy level, and the second amplifier 550 and the third amplifier 750 that amplify the amplified light again.

The pre-amp optical unit 300 has the configuration described in FIGS. 2 and 3A to 3C.

The second amplifier 550 includes a second pumping light source 551 and a second amplification medium 553. The second amplification medium 553 absorbs energy of the light supplied from the second pumping light source 551, further amplifies energy of the laser light L whose energy is primarily amplified by the pre-amp optical unit 300, and outputs it. The second amplification medium 553 may be Nd:YAG (neodymium-doped yttrium aluminum garnet), but is not limited thereto, and Nd:YAP (Neodymium:Yttrium-Aluminum-Perovskite), or Nd:YVO4 (Neodymium-doped yttrium orthovanadate), or so on may be used as the second amplification medium 553.

The third amplifier 750 includes a third pumping light source 751 and a third amplification medium 753. The third amplification medium 753 absorbs energy of the light supplied from the third pumping light source 751, amplifies energy of the laser light L amplified by the second amplifier 550 again, and outputs the amplified energy. The third amplification medium 753 may be Nd:YAG (neodymium-doped yttrium aluminum garnet), but is not limited thereto, and Nd:YAP (Neodymium:Yttrium-Aluminum-Perovskite), or Nd:YVO4 (Neodymium-doped yttrium orthovanadate), or so on may be used as the third amplification medium 753.

The control unit 800 applies the pulse signal PS for the pulse pattern of the laser light L to be output from the laser diode 100 to the driver of the laser diode 100. Additionally, in conjunction therewith, control signals SG1, SG2, and SG3 are transmitted to the pre-amp optical unit 300, the second amplifier 550, and the third amplifier 750. For example, the control signals SG1, SG2, and SG3 may be timing signals that turn on/off the pumping light source providing light to be supplied to each amplification medium of the first amplifier 350, the second amplifier 550, and the third amplifier 750.

A first beam expansion unit 410 that expands the beam width of the laser light amplified by the pre-amp optical unit 300 may be further arranged between the pre-amp optical unit 300 and the second amplifier 550. Additionally, a second beam expansion unit 420 may be further arranged to further expand the beam width that is expanded in the first beam expansion unit 410. The second beam expansion unit 420 may be between the second amplifier 550 and the third amplifier 750. The first beam expansion unit 410 and the second beam expansion unit 420 may each include one or more lenses, and are not limited to the shapes and numbers illustrated. Path changing members 610 and 620 for changing the optical path may be between the second amplifier 550 and the third amplifier 750.

The laser device 1001 may further include a second harmonic wave generation unit 900 in the path of the light output from the third amplifier 750.

The second harmonic wave generation unit 900 converts the frequency of the incident light into two times (frequency doubling) and outputs it. The second harmonic wave generation unit 900 may include a plurality of mirrors and a nonlinear medium. A second harmonic generation (SHG) crystal may be used as the nonlinear medium, for example, KTP, LBO, or BBO may be used. The light of the first wavelength incident on the second harmonic wave generation unit 900 reciprocates the optical path between the plurality of mirrors and the nonlinear medium therebetween, and light of which the wavelength is converted to the second wavelength is emitted. Light of which the wavelength is not converted is incident on the nonlinear medium again, is converted to light having the second wavelength, and then emitted. The first wavelength may be the wavelength of light generated by the laser diode 100, for example, 1064 nm, and the second wavelength may be 532 nm. However, the present disclosure is not limited thereto.

The second harmonic wave generation unit 900 may be driven and controlled to change its position along the direction A. The second harmonic wave generation unit 900 is located within the output path of the laser light L, and accordingly, the light output from the laser diode 100 may be output with wavelength changed by half. When the second harmonic wave generation unit 900 is located outside the output path of the laser light L, the light output from the laser diode 100 may be output without wavelength changing.

Although the position of the second harmonic wave generation unit 900 is illustrated to be moved directly, this is just an example, and a driving mirror that moves so that the amplified laser light L can be directed toward the second harmonic wave generation unit 900 or toward another path may be utilized.

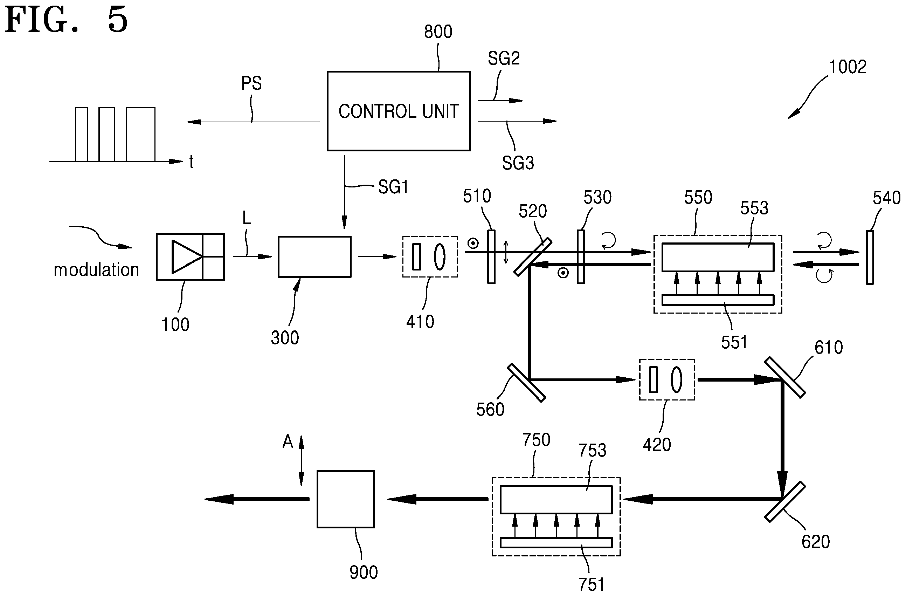

FIG. 5 illustrates a schematic optical arrangement of a laser device according to another embodiment.

The laser device 1002 of the present embodiment differs from the laser device 1001 in that the laser device 1002 is configured to amplify the laser light L through the second amplifier 550 twice, and the other configurations are substantially the same as that the configurations of the laser device 1001 of FIG. 4, and accordingly, only the differences are described.

In addition to the configuration of the laser device 1001 described in FIG. 4, the laser device 1002 further includes a half wave plate 510 between the pre-amp optical unit 300 and the second amplifier 550, a polarization beam splitter 520 between the half wave plate 510 and the second amplifier 550, a quarter wave plate 530 between the polarization beam splitter 520 and the second amplifier 550, and a total reflection mirror 540 that reflects light passing through the second amplifier 550 back toward the second amplifier 550.

As described with reference to FIGS. 3A to 3C, if the laser light L output from the laser diode 100 is light of the first polarization, the light amplified and output from the pre-amp optical unit 300 has also the first polarization state. The half wave plate 510 changes the polarization state of the laser light L from the first polarization to the second polarization, and the light of the second polarization passes through the polarization beam splitter 520. Next, the light of the second polarization becomes the light of the left-handed circular polarization as passing through the quarter wave plate 530, and when passing through the second amplifier 550 and being reflected from the total reflection mirror 540, the light of the second polarization becomes the light of the right-handed circular polarization. Next, the light of the right-circular polarization passes through the quarter wave plate 530 and changes into the light of the first polarization, is reflected from the polarization beam splitter 520, and is directed to the third amplifier 750. According to the optical arrangement, the laser light L reciprocates the second amplifier 550, that is, passes through the second amplifier 550 twice, and then is directed toward the third amplifier 750.

A path changing member 560 may be between the polarization beam splitter 520 and the third amplifier 750. The arrangement position of the path changing member 560 is not limited to the position illustrated, and the arrangement order may be changed with the second beam expansion unit 420.

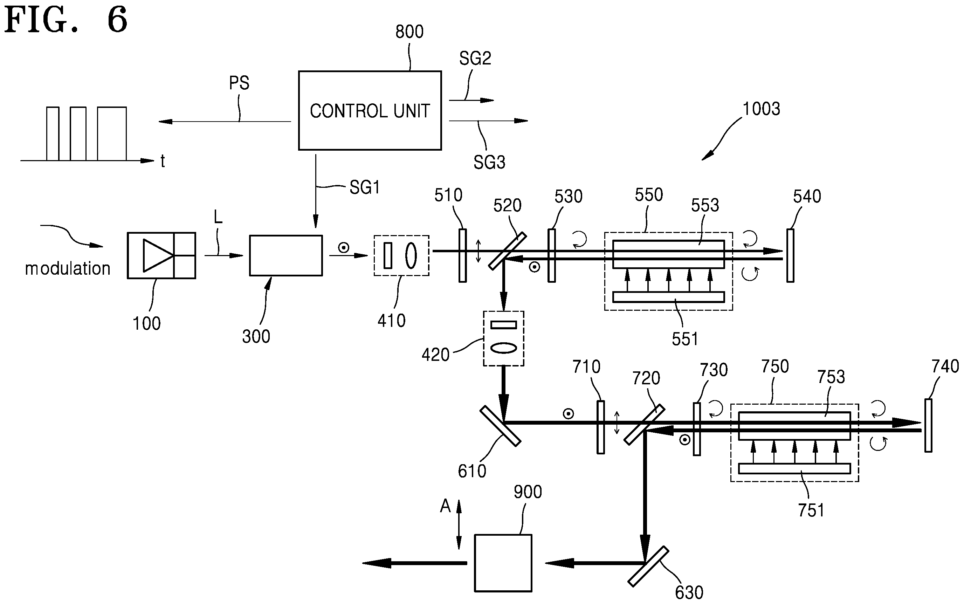

FIG. 6 illustrates a schematic optical arrangement of a laser device according to another embodiment.

A laser device 1003 of the present embodiment differs from the laser device 1002 in that the laser device 1003 is configured to amplify the laser light L through the third amplifier 750 twice, and the other configurations are substantially the same as the configurations of the laser device 1002 of FIG. 5. and accordingly, only the differences are described.

In addition to the configuration of the laser device 1002 described in FIG. 5, the laser device 1003 includes a half wave plate 710 between the second amplifier 550 and the third amplifier 750, a polarization beam splitter 720 between the half wave plate 710 and the third amplifier 750, a quarter wave plate 730 between the polarization beam splitter 720 and the third amplifier 750, and a third total reflection mirror 740 that reflects light passing through the third amplifier 750 back toward the third amplifier 750.

As described in FIG. 5, the light of the first polarization passing through the second amplifier 550 and being directed toward the third amplifier 750 changes into the light of the second polarization during passing through the half wave plate 710, and the light of the second polarization passes through the polarization beam splitter 720. Next, the light of the second polarization becomes light of the left-handed circular polarization as passing through the quarter wave plate 730, the light of the left-handed circular polarization passes through the third amplifier 750, and the light of the left-handed circular polarization is reflected from the total reflection mirror 740 with changing into light of right-handed circular polarization. Next, the light of the right-handed circular polarization passes through the quarter wave plate 730 and changes into the light of the first polarization, and then, the light of the first polarization is reflected from the polarization beam splitter 720, and is directed toward the output end. According to the optical arrangement, the laser light L reciprocates the second amplifier 550, that is, passes through the second amplifier 550 twice, and also reciprocates the third amplifier 750, that is, passes through the third amplifier 750 twice, and then is output. However, the present disclosure is not limited thereto and may be changed to be output after passing through the second amplifier 550 once and the third amplifier 750 twice.

In the description of FIGS. 4 to 6, the second amplifier 550 and the third amplifier 750 are described as being implemented with a single pass or two pass optical system, but any one or all of the components may be changed to a four pass optical system. For this path, for example, a Pockels Cell operating as a variable half wave plate or a variable quarter wave plate may be used, and in addition, a half reflecting mirror or a beam splitter may be used together.

The laser devices 1000, 1001, 1002, and 1003 described above are capable of outputting variable pulse laser light in a wide range by adjusting the current and voltage signals of the driver of the laser diode 100, and capable of being used as treatment devices. The pulse width range is available from pico-seconds to nano-seconds, and may have a variable pulse width range of, for example, 50 ps to 5 ns or 50 ps to 100 ns. The laser device may be expected to provide more effective treatment results compared to existing pico-second lasers.

Existing pico-second laser devices output a laser with a fixed pulse width without changing the pulse width, or additionally output a laser with a fixed pulse width of nano-seconds. In this case, the nano-second output laser refers to a group of two pico-second pulses that is output by dividing the pico-second laser pulse with a time difference of 1 to 2 ns, and is not a true nano-second pulse.

In contrast, the laser device according to the embodiment uses a laser diode with a variable pulse width laser from 50 ps to 5 ns as a seed laser source and amplifies the laser to a required energy level, thereby outputting laser light having a variable pulse width from pico-seconds to true nano-seconds.

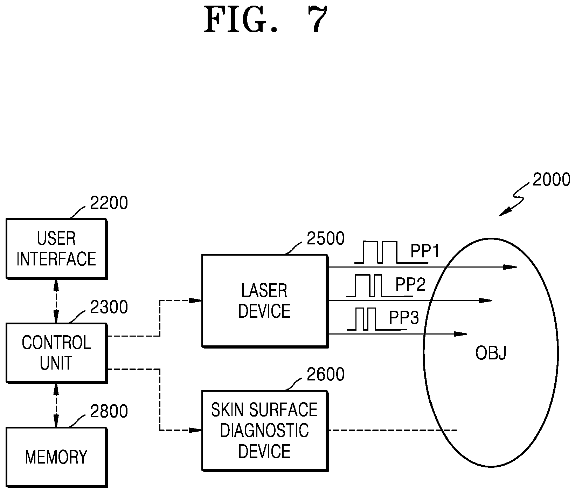

FIG. 7 is a block diagram illustrating a schematic configuration of a treatment device according to an embodiment.

A treatment device 2000 includes a laser device 2500 and a control unit 2300 that drives the laser device. The laser device 2500 may include any one of the laser devices 1000, 1001, 1002, and 1003 according to the above-described embodiments, or a modified configuration thereof. The control unit 2300 may set a pulse pattern suitable for a treatment mode of the laser device 2500 and drive the laser device 2500 to output laser light of a set pulse pattern. The control unit 2300 may also select the wavelength of the laser light output from the laser device 2500. The treatment device 2000 may further include a skin surface diagnostic device 2600 for diagnosing a skin condition of an object OBJ and a memory 2800 that stores information used to control the laser device 2500, and may further include a user interface 2200. The user interface 2200 may include a display unit and an input unit. The input unit may include, for example, a keyboard, a touch panel, or the like.

The pulse pattern of the laser light output from the laser device 2500 may be, for example, a pulse pattern PP1 including only nano-second pulses, a pulse pattern PP2 including a combination of nano-second pulses and pico-second pulses, and a pulse pattern PP3 including only pico-second pulses or so on.

In skin treatment using the laser light, different types and different energies of lasers may be needed depending on the type of pigmented lesion. For example, the nano-second laser pulses may be appropriate for the treatment of epidermal lesions such as freckles and blemishes, and in the case of treatment of lesions deep in the dermal layer of the skin or when it is necessary to split pigment particles into small sizes during pigment treatment, the pico-second laser pulses may be appropriate to use. In some cases, the nano-second laser pulses and the pico-second laser pulses may be used together, pulses with different pulse widths in the pico-second region may be combined and used together, pulses with different pulse widths in the nano-second region may be combined and used together, and new clinical effects may be expected from such a combination.

For example, even in the pico-second region, if the photomechanical effect needs to be increased according to clinical purposes or treatment sequence, a pulse width of less than 300 ps may be desirable. However, in this case, there may be cases where plasma is generated at low energy due to high peak power, which interferes with reaching deep skin regions, reducing the treatment effect. Therefore, a longer pulse width of the pico pulse width, for example, a pulse width of about 700 ps, may be appropriate. In this case, a pulse with a pulse width of less than 300 ps and a pico-second pulse with a pulse width of about 700 ps, for example, in the range of 600 ps to 800 ps, may be used together.

Additionally, in order to use the photothermal effect in treatment, nano-second pulses with a pulse width of 5 ns or pulse widths up to 50 ns or 100 ns may be used.

The treatment device 2000 may provide laser light with a variable pulse width, for example, in the range of 50 pico-seconds to 100 nano-seconds, thereby providing a treatment method appropriate for the type of lesion and expecting improvement of clinical effects.

As such, the present disclosure has been described with reference to an embodiment illustrated in the drawings, but this is merely an example, and those skilled in the art will understand that various modifications and variations of the embodiment are possible therefrom. Therefore, the true scope of technical protection of the present disclosure should be determined by the technical spirit of the attached claims.

## Claims

1. A laser device comprising:
a laser diode configured to output laser light with a variable pulse pattern;
a pre-amp optical unit configured to amplify the laser light output from the laser diode to a first energy level and including a plurality of Pockels cells and a first amplifier;
a second amplifier configured to amplify the laser light amplified to the first energy level to a second energy level;
a third amplifier configured to amplify the laser light amplified to the second energy level to a third energy level; and
a control unit configured to set a pulse pattern of the laser light output from the laser diode and control a driver of the laser diode, the first amplifier, the second amplifier, and the third amplifier based on the pulse pattern.

2. The laser device of claim 1, wherein the pulse pattern includes one or more pulses having a pulse width in a range of 50 pico seconds to 100 nano seconds.

3. The laser device of claim 1, wherein the pre-amp optical unit includes:
a polarization beam splitter configured to reflect light of a first polarization and transmit light of a second polarization;
a first Pockels cell arranged in a path of light reflected from the polarization beam splitter and controlled to operate as a quarter wave plate at a first timing;
the first amplifier configured to amplify the light passing through the first Pockels cell;
a first total reflection mirror configured to reflect the light amplified and output from the first amplifier back toward the first amplifier again;
a second Pockels cell arranged to face the first Pockels cell with the polarization beam splitter between the first Pockels cell and the second Pockels cell and controlled to operate as a quarter wave plate at a second timing; and
a second total reflection mirror configured to reflect the light passing through the second Pockels cell back toward the second Pockels cell again.

4. The laser device of claim 3, wherein the laser light output from the laser diode is the light of the first polarization.

5. The laser device of claim 4, wherein the first timing is a time from an instant when the laser light is reflected from the polarization beam splitter to an instant when the laser light reciprocates the first amplifier once and returns back to the polarization beam splitter again.

6. The laser device of claim 4, wherein the second timing is a time from an instant when the laser light reciprocates the first amplifier multiple times to an instant when the laser light has a first energy level and then reciprocates the second Pockels cell once.

7. The laser device of claim 1, wherein the first energy level is greater than or equal to 100 microjoules (µJ).

8. The laser device of claim 6, wherein a number of times that the laser light reciprocates to the first amplifier is 5 to 20 times.

9. The laser device of claim 1, further comprising a first beam expansion unit configured to expand a beam width of the laser light amplified by the pre-amp optical unit.

10. The laser device of claim 9, further comprising a second beam expansion unit configured to further expand the beam width expanded in the first beam expansion unit.

11. The laser device of claim 1, further comprising a second harmonic wave generation unit arranged in a path of light output from the third amplifier.

12. The laser device of claim 11, wherein the second harmonic wave generation unit is driven to be inside or outside the path.

13. The laser device of claim 1, further comprising:
a half wave plate arranged between the pre-amp optical unit and the second amplifier;
a polarization beam splitter arranged between the half wave plate and the second amplifier;
a quarter wave plate arranged between the polarization beam splitter and the second amplifier; and
a total reflection mirror configured to reflect the light passing through the second amplifier back toward the second amplifier again.

14. The laser device of claim 1, further comprising:
a half wave plate arranged between the second amplifier and the third amplifier;
a polarization beam splitter arranged between the half wave plate and the third amplifier;
a quarter wave plate arranged between the polarization beam splitter and the third amplifier; and
a total reflection mirror configured to reflect the light passing through the third amplifier back toward the third amplifier again.

15. A treatment device comprising:
the laser device according to any one of claims 1 to 14; and
a control unit configured to control the laser device to output a pulse pattern suitable for a treatment mode.

16. The treatment device of claim 15, wherein the laser device is configured to output light of a pulse pattern including only pico-second pulses, output light of a pulse pattern including only nano-second pulses, or output light of a pulse pattern including a combination of pico-second pulses and nano-second pulses.
